# EUROPEAN PATENT SPECIFICATION

(11) **EP 1 641 956 B1**
(45) Date of publication and mention of the grant of the patent: **25.03.2009**
(21) Application number: 04741896.7
(22) Date of filing: 25.06.2004
(51) Int. Cl.: C23C 14/34, H01J 37/34

(54) **ROTATING TUBULAR SPUTTER TARGET ASSEMBLY**
ROTIERENDE ROHRFÖRMIGE SPUTTERTARGETANORNDUNG
SYSTEME DE CIBLE DE PULVERISATION TUBULAIRE ROTATIF

(30) Priority: 04.07.2003 EP 03077091
(43) Date of publication of application: 05.04.2006
(73) Proprietor: Bekaert Advanced Coatings, 9800 Deinze (BE)
(72) Inventor: CNOCKAERT, Dirk, 9800 Deinze (BE); DE BOSSCHER, Wilmert, 9031 Drongen (BE)
(74) Representative: Messely, Marc
(86) International application number: PCT/EP2004/051247
(87) International publication number: WO 2005/005682

(56) References cited:
- US-A- 4 422 916
- US-A- 5 096 562
- US-A- 5 200 049
- US-A- 5 725 746

## Description

### Field of the invention.

The invention relates to a target assembly comprising a central body in a rotatable target tube.

### Background of the invention.

The use of rotatable targets for large area plasma deposition of thin films onto e.g. window glass has become widespread. Metallic deposition - under an inert gas atmosphere - as well as the deposition of compound materials - when a reactive gas is mixed with the inert gas - are performed on an industrial scale in large sputter deposition installations. One of the key components in this process remains the target assembly, which has to fulfil all of the following functions:
- It has to keep the magnetic field source in place. The generated magnetic field at the outside of the tube confines the electrons in a narrow closed loop track leading to an increased ionisation of the inert gas atoms.
- The assembly must support the target tube rotatably.
- The target surface must be rotated in front of the magnetic field source so that each segment of the tube can be exposed to the plasma thus eroding in a uniform way all the target material at the outside of the tube.
- The target surface must be kept at a negative potential with respect to the chamber. This potential accelerates the positive ions in the plasma towards the target surface thus ejecting the atoms from the target into the chamber. As this leads to neutralisation of the target a negative electrical current must be maintained towards the target in order to maintain this potential.
- The target assembly has to be cooled because the dense bombardment of the surface leads to an intense heating that would quickly lead to damage of the target assembly and/or melting of the target material.
- The target assembly must be vacuum tight in order to prevent the contamination of the deposition chamber and maintain gas composition.

While each of these functionalities are relatively simple to attain individually, the combination of all of them in a single assembly is a technological problem in its own right.

One of the first attempts to construct a rotatable magnetron is described in US 4 422 916 that discloses a rotatable magnetron wherein coolant is injected at one end and collected at the other end. Particular of this embodiment is that bearing sleeves and coolant-to-vacuum seals are inside the tubular target.

Another assembly described in US patent 5 096 562 solved the problem by dividing the functionalities as follows:
- Within the removable target tube the magnets were mounted on a stationary coolant feedthrough.
- A first end-block was so designed that it allowed for the transmission of rotary movement and the supply and withdrawal of coolant by means of a rotary coolant seal to the target.
- A second end-block at the other end of the target tube contained the rotary connection of electrical current

Cantilever mounted rotatable targets - as described in e.g. US 5 200 049 - integrate all functions into one bearing housing having one end extending into the chamber and the other end located outside the chamber. The cantilever bearing housing must be mounted on a wall perpendicular to the axis of the target. A particular example is described in US 5 725 746 wherein a cooling tube - carrying the magnetic field source - extends inside of the target towards the free hanging target end. The target is capped with an end closure wherein a bearing means inside the tube helps to carry the cooling tube so that it does not sag too much. Hence, the cooling tube is supported by the target (it is not the target that is supported by the cooling tube). While these designs made the use of large target tubes practical, the end blocks or the bearing housing have a serious drawback in that they occupy a substantial part of the chamber which cannot longer be used for deposition of material, but anyhow has to be pumped vacuum. Moreover, they decrease the useable deposition width of the installation. In case of a cantilever target assembly the usage becomes more difficult if it is the intention to mount the magnetron along the length of and on a removable cover, door or lid.

In addition, the voluminous end-blocks or the bearing housing inhibit the use of rotatable target tubes in smaller size installations. In these smaller installations in many cases a planar target is used which has the drawback that it needs to be replaced more frequently (once every 4 to 5 days) compared to rotatable targets (replacement every 3 to 4 weeks). As a result the existing end-blocks or cantilevered housings are difficult to mount in e.g. a vertical coater such as a display coater.

### Summary of the invention.

It is a general object of this invention to do away with the drawbacks of the prior art. It is a first object of the invention to minimise the space requirements of the end-blocks. On installations where now prior art end-blocks are used, the invention thus allows for a better use of the vacuum space and in particular the width of the chamber. It is a further object of the invention to enable the use of rotary targets in small sized installations where now only planar magnetrons can be used. The invention can thus reduce the replacement rate of the target and improve the use of the target material thus saving cost and time in these smaller sized installations.

The invention relates to the combination of features as described in claim 1. A target assembly comprising a central body in a rotatable target tube is claimed. Functionalities, which in the prior art are incorporated into the end-block, are now implemented inside the target tube. These functionalities are:
(1) a bearing system for rotatably supporting the tube by the central body
(4) at least one rotatable gas-to-coolant seal for supplying and extracting coolant to the tube
(5) at least one rotatable gas-to-vacuum seal for enabling a vacuum outside said tube

In case the target assembly is used in a magnetron deposition apparatus, a magnet array is obviously understood to be incorporated into the tube as well.

With the rotatable gas-to-coolant seal is meant a seal that physically separates a gas containing space from a coolant containing space while enabling a rotary movement between both spaces.

Mutatis mutandis, a rotatable gas-to-vacuum seal is a seal that physically separates a gas containing space from a vacuum containing space while enabling a rotary movement between both spaces.

Mostly the gas will be air at ambient or somewhat lower pressure (1 kPa at the lowest). Alternatively, the gas can be nitrogen or argon at ambient or low pressure (1kPa at the lowest).

With 'inside the target tube' or 'interior of the target tube' is meant: the space enclosed by the rotatable target material carrying tube of the apparatus.

The invention relates to embodiments where besides the gas-to-coolant seal and the gas-to-vacuum seal also the bearing system is inside the tube and the bearing is put in between the gas-to-coolant seal and the gas-to-vacuum seal in order to avoid lubricant contamination.

Favored are the embodiments where besides the gas-to-coolant seal and the gas-to-vacuum seal and the bearing system, the drive means is inside the tube.

Another favored arrangement of the invention is when besides the gas-to-coolant seal and the gas-to-vacuum seal and the bearing system the electrical contact is incorporated inside the tube.

Least preferred is the combination where all the functionalities i.e. the gas-to-coolant seal and the gas-to-vacuum seal and the electrical contact and the bearing system and the drive means is incorporated inside the tube as this is the most complex implementation (although not impossible as will be illustrated lateron).

The implementations of the different functionalities are discussed in more detail hereafter.

The bearing system can be any suitable bearing system that is appropriate to carry the load associated with the total assembly. The bearing system could be mounted between the central body and the target tube, but preferably it will be incorporated into the central body. In this way the central body comprises a stationary part connected to the chamber and a rotatable part turning with the target tube. As an example, one can think of targets that are operated in a horizontal position. There, ball bearings or roller bearings will be more appropriate for larger spans. For smaller spans a plain bearing will do. In case the target is mounted vertically, an axial bearing will be preferred for the lower or upper bearing, while a radial bearing may suffice to support respectively the topside or downside of the tube.

With 'drive means' is meant that device which transforms any form of non-mechanical energy into mechanical rotation. The drive means must allow for a rotational speed of at the most 60 rotations per minute. An adjustable speed is preferred although not necessary.

In case of DC cathodic operation, negative charge has to be fed continuously to the target tube. This is according the present invention achieved by mounting an electrical contact between the body and the tube inside the tube. The contact is ensured through an electrically connecting brush, bushing or slip ring of e.g. copper filled graphite or any other material known in the art for this purpose. Also the brush can be spring activated in order to ensure a good electrical contact. In case the contact is made by this art, it is preferred that the electrical contact is obtained under dry conditions i.e. the materials ensuring the electrical contact between body and tube do not come into contact with the coolant. Contrary, an electrical contact where the electrical current flow is established through a fluid - e.g. the coolant - is a possible alternative. The maximum current to be transferred by this connection is dependent on the magnitude of the installation. Typically - without being delimited - is a value of at the most 400 A. The case of AC operation - in which the target is alternatively positively and negatively charged - or pulsed DC operation - in which the DC operation is interrupted according a pattern - is also included. Use of the target assembly as a positively charged anode, for example to coat the bare tube with material or as a collector of electrons on a periodic or continuous base, is explicitly included in the invention.

Coolant is supplied and extracted continuously to the inner surface of the tube in order to keep the assembly at an acceptable temperature level (typically below 45°C). Coolant supply and extraction can be situated at the same side of the target tube or the supply can be at one side and the extraction at the other. The former is preferred since then only one rotatable gas-to-coolant seal can suffice provided the coolant supply and extraction are done through e.g. concentric tubes. In case a leak would occur in the gas-to-coolant seal, the coolant will leak to a gas pressure section and not to the vacuum section of the apparatus.

Coolant is preferably water, although other coolants could be envisaged as well as long as they fulfil the requirements of heat capacity, electrical conductivity and viscosity. The coolant is supplied at a pressure of typically 5 bar and at a rate which is dependant on the power rating of the deposition installation which is itself a function of the magnitude of the installation. Typically lip seals are used as gas-to-coolant seal as they are well known in the art. However, other types of seals like mechanical face seals or labyrinth seals - without being exhaustive - are not excluded.

In order to maintain vacuum and/or the low pressure gas composition in the chamber no gas should be able to leak into the chamber. The transition between the stationary and rotating part of the central body is ensured by means of a rotatable gas-to-vacuum seal, separating the vacuum section from the gas atmosphere while allowing for rotation. In case a leak would occur, the gas will leak to the vacuum section. This seal is either based on lip seal type of assemblies and/or ferrofluïdic seal types. The former relies on mechanical squeezing of a high performance elastomer against the other rotating part (as in the case of the coolant seal). The latter's working principle is based on the formation of a fluidic ring between the shaft and a pole shoe fitting the shaft. The fluid - which contains finely dispersed magnetic particles - is held between shaft and pole shoe by means of the magnetic field. When the target tube is mounted in a cantilevered way, one gas-to-vacuum seal would suffice. In case the target tube is held at both ends, two vacuum gas-to-vacuum seals are preferred.

In the above the functionalities have been discussed separately. Nowadays, combinations of different functionalities can be bought integrated in one package. For example, it is possible to obtain gas-to-vacuum seals in which also bearings are incorporated. Or electrical brushes that are isolated from external liquids, which hence also can be used as gas-to-coolant seal. It is clear that these combinations fulfil the requirement also as put forward in claim 1. However, the one combination of gas-to-coolant seal and a gas-to-vacuum seal i.e. a coolant-to-vacuum seal is less preferred, as this is known to cause problems when the seal is not perfect. Such failures may lead to coolant leaking out into the vacuum system resulting in costly replacement of vacuum equipment or costly downtime.

In the dependent claims, different embodiments of the invention are defined which will now be discussed in more detail.

As a drive means an electrical motor can be used. This motor is preferably of the fixed axis, rotating drum type, since this simplifies the mounting of the motor.

As an alternative to an electrical motor, a hydraulic rotary motor is also possible. More preferred is the use of the circulating coolant as the propellant for this hydraulic motor, thus further simplifying the concept.

While the above focuses on the target assembly as such, the assembly has also to be fixed to the walls of the sputtering apparatus. It is not excluded that the whole sputtering apparatus is mounted for example to an access door or lid of the vacuum chamber. The fixation to the apparatus is done by coupling means. These coupling means distinguish themselves from the prior art end-blocks in their simplicity and relative smallness. Indeed the coupling between the central body and the coupling means contains no moving parts: the coupling means have only to keep the stationary part of the central body fixed with respect to the chamber and to provide a stationary feedthrough of electricity for charging the target surface, of coolant and of electricity for the drive means (if needed). In which one of the two coupling means these feedthroughs are organised is of course dictated by how the functionalities inside the central body are organised.

By way of non-delimiting example, the electricity to charge the surface can be supplied at the same side where the coolant is supplied while the electricity to energise the drive means (if needed) is supplied on the other side.

If the central body is so organised that all supply feedthroughs are e.g. available at a first coupling means to the central body, the task of the second coupling means limits itself to holding the central body itself. In the limit this second coupling can be completely eliminated in case the mechanical strength of the first coupling is sufficient to hold the target assembly in place.

The central body can also be separated into a first and a second central body that are mechanically detachable from one another. In this way both bodies can be inserted separately from one another at both ends of the target tube. The functionalities can be divided between both bodies in the most convenient way, as long as at least one of them is incorporated inside the target tube. The first and the second central body can be mechanically coupled to one another. This can for example be realised by using the magnet array as the coupling means. These embodiments are also envisaged in the invention. Again coupling means for coupling the first and second central body have to be provided in the magnetron apparatus. The case where one side of the target assembly holds the tube is also included.

### Brief description of the drawings.

The invention will now be described into more detail with reference to the accompanying drawings wherein
- FIGURE 1: is an overview of a first preferred embodiment of the target assembly including the coupling means, in a front view and a side view.
- FIGURE 2: is a cross section of the first preferred embodiment according plane AA' of FIGURE 1
- FIGURE 3: is a cross section according line BB' of FIGURE 1
- FIGURE 4: is a cross section according line CC' of FIGURE 1;
- FIGURE 5: is cross section of a second preferred embodiment where the drive means is hydraulic rotary motor driven by the coolant.
- FIGURE 6: shows a preferred embodiment with the bearing system and the gas-to-vacuum seal and the gas-to-coolant seal inside the target tube while the other functionalities are implemented outside the tube
- FIGURE 7: shows a preferred embodiment with the bearing system and the gas-to-vacuum seal and the gas-to-coolant and the electrical contact inside the target tube while the other functionalities are implemented outside the tube.
In the figures identical reference numbers will be used for the same parts occurring in different cross sections.

### Description of the preferred embodiments of the invention.

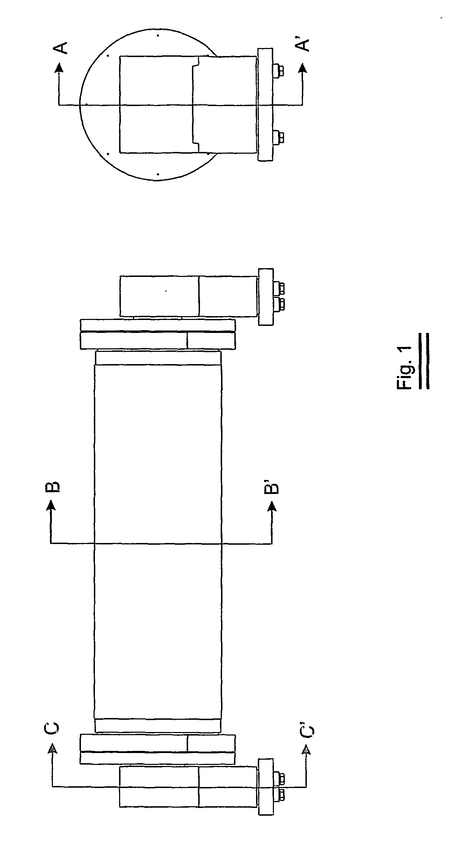

As the working principle of rotatable target assemblies is generally known in the art, focus will be given to the detailed description of the invention of which a first preferred embodiment is represented in FIGURE 1.

In this embodiment all the functionalities as enumerated in claim 1 are incorporated inside the target tube. The drive means is an electrical motor. The supply and extraction of the coolant and the charging of the surface is through a first coupling means. The electricity to drive the electrical motor is fed through a second coupling means.

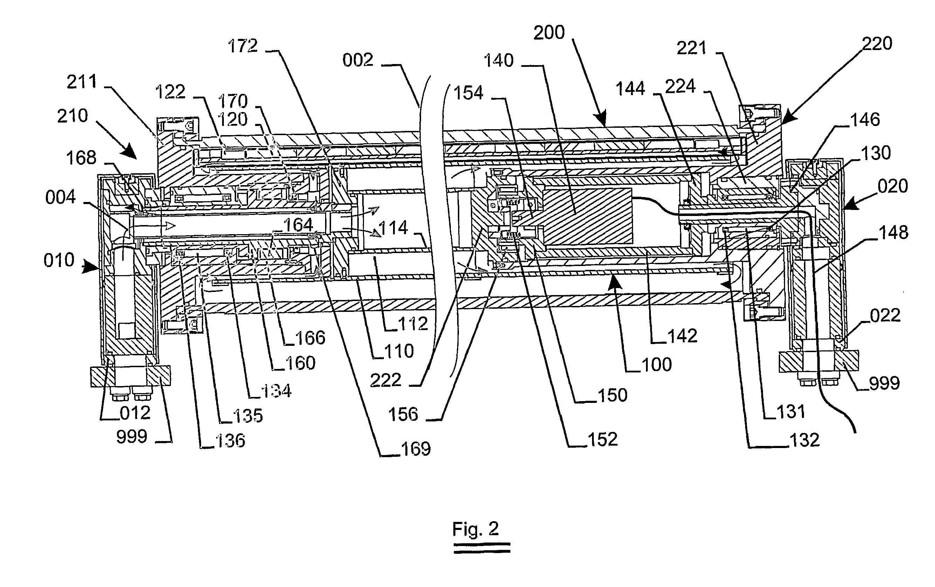

FIGURE 2 shows the carrier tube 100 and the rotating tube 200. The rotating tube 200 can be made of the target material itself e.g. aluminium tube. Or the target material can be disposed at the outside of the rotating tube. It can be applied onto the tube 200 by means of thermal plasma torch spraying, or by electrolytic deposition, or by any other technique known in the art. The total length of the tube can be chosen at will by increasing or decreasing the length between the wavy lines 002. At both ends of the tube 200 an insert 210 and 220 can be slid into the tube 200 thus forming a central body together with the carrier tube 100. For convenience we will refer to the first side of the tube as that side coupled to the first coupling means 010 and the mutatis mutandis for the second side.

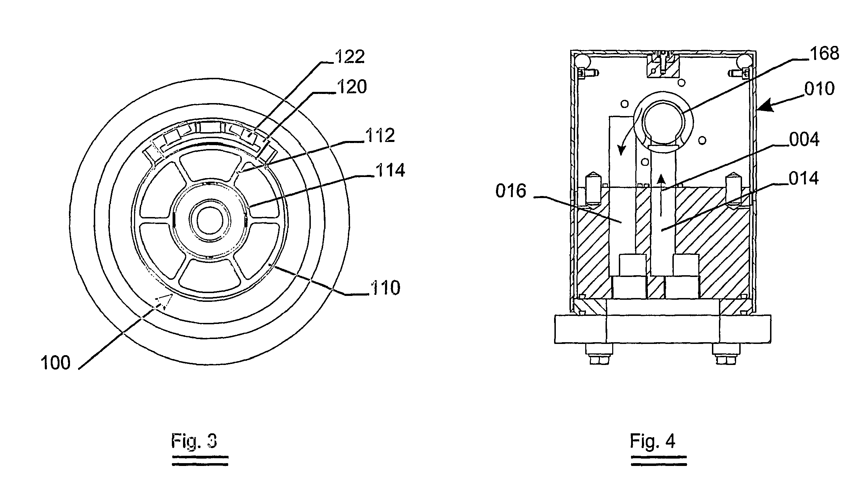

The carrier tube 100 (FIGURE 3) comprises an extruded Duraluminum double walled tube where the inner tube 114 is connected to the outer tube 110 through six ribs 112. This is the main carrier structure to which the other parts are connected. The magnet holder 120 is mounted to the outer side of the carrier structure 110. Permanent magnets 122 are arranged onto this holder 120. Suitable magnetic arrangements have been described in WO 99/54911. The target assembly is rotatable supported by 4 bearings 130,132,134 and 136 (FIGURE 2) which are incorporated inside the central tube 114 of the double walled tube. The drive means, in this case a rotary shaft electrical motor 140, is mounted inside a cylindrical housing 142 which is capped with a circular lid 144 at the outer side of the target assembly. A feedthrough piece 146 acting also as the axis for rotatably supporting the tube is used to supply power leads 148 to the motor. At the other side of the motor housing the shaft is fed through a circular fitting piece 150. The shaft of the motor 154 is fastened to a closing piece 222 for the insert 220. This closing piece 222 is made of an electrically insulating material in order to electrically insulate the motor 140 from the insert piece 221 which is at the potential of the tube. In addition a mechanical connector 152 for absorbing start and stop shocks and a bearing 156 to increase the mechanical stability of the design are mounted between fitting piece 150 and closing piece 222. Also an insulating bushing 224 is introduced between the second insert 220 and feedthrough piece 146 in order to insulate the motor 140 and second coupling means 020 from the target potential. Additional electrical insulation is obtained by introducing an insulator plate 022 between the chamber wall 999 and the second coupling piece 020.

The electrical contact for electrically connecting the target tube to the target power supply is incorporated into the first insert 210. The insert piece 211 rotates around the axial tubular piece 160. Power is transferred through the first coupling means 010 and the first insert 210 to the rest of the tube. This means that first coupling means 010 is at the higher potential of the target tube. An insulator 012 has therefore been introduced between the first coupling means 010 and the vacuum chamber wall 999. Electrical contact is ensured through the stationary brush 164 that is spring loaded against the rotating bushing 166. It is evident that the materials used for the different parts should be conductive such that an electrical path of sufficient current capacity can be formed between the first coupling 010 and the surface of the target tube 200. When the applied voltage is negative, the target tube 200 acts as a cathode, e.g. for accelerating positive ions towards its surface. When the applied voltage is positive, the target tube 200 acts as an anode, e.g. for collecting electrons.

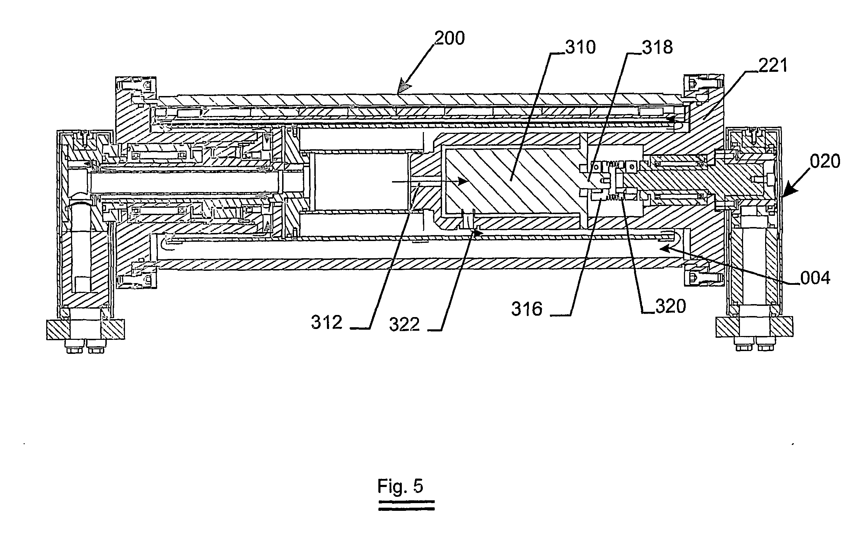

The coolant is supplied through the first coupling means 010. A series of arrows 004 indicates the track followed by the coolant. FIGURE 4 gives a cross section of the first coupling piece 010 to the first insert 210. The coolant is fed through a bore hole 014 in the middle of the first coupling means to a tube 168 which is coaxially mounted to the axial tubular piece 160. The cold coolant going into the target assembly is separated from the warm coolant returning from the target assembly through a separator 172 that is mounted between inner 114 and outer tube 110 of the carrier tube 100. The central feed tube 168 feeds directly into the carrier inner tube 114 where the coolant is further guided towards the second side of the tube. There the flow reverses and the coolant is pressed towards the first end of the tube thus cooling the hot outer target tube 200. At the first end the flow is again reversed and led into the cylindrical, coaxial gap between the tube 168 and the axial tubular piece 160 through the exit holes 169. The design necessitates only one water seal 170, which is a lip seal. The warm coolant is led through a borehole 016 (FIGURE 4) sideways from the entrance borehole 014. The vacuum seal is necessary in order to guarantee the vacuum or the low-pressure gas composition. In this preferred embodiment this is achieved by introducing vacuum seals 135 and 131 between the two pairs of bearings 134, 136 and 130, 132. In fact the vacuum seal and the bearing are part of an assembly that can be obtained preassembled. FIGURE 5 depicts a second preferred embodiment in which the drive means is replaced by a hydraulic motor. As this particular embodiment is identical for the other functionalities (bearing system, electrical contact, rotatable coolant seal and rotatable vacuum seal) to that of the first embodiment the clarification of FIGURE 5 will be focused on the hydraulic motor only. This motor is driven by means of the coolant itself. The flow of the coolant is therefore guided through the feed hole 312 into the hydraulic motor 310. In the motor, the kinetic energy of the flow is transformed into rotary movement. Upon exiting through the exit holes 322, the coolant is guided to the inside of the target tube 200 to further cool the tube. The rotating outer housing of the motor is affixed to the insert piece 221, while the axis of the motor 318 is fixed through a mechanical connector 316 that allows easy fixing of the motor axis to the central axis 320 as well as absorbs start and stop shocks. The central axis 320 is immovably mounted to the second coupling means 020. The functioning of the motor can be based on guide vanes under angle as in a turbine or on the principle of an orbital motor or an inverted screw pump principle or any other principle known in the art. The principle of operation is however non-delimiting to the invention.

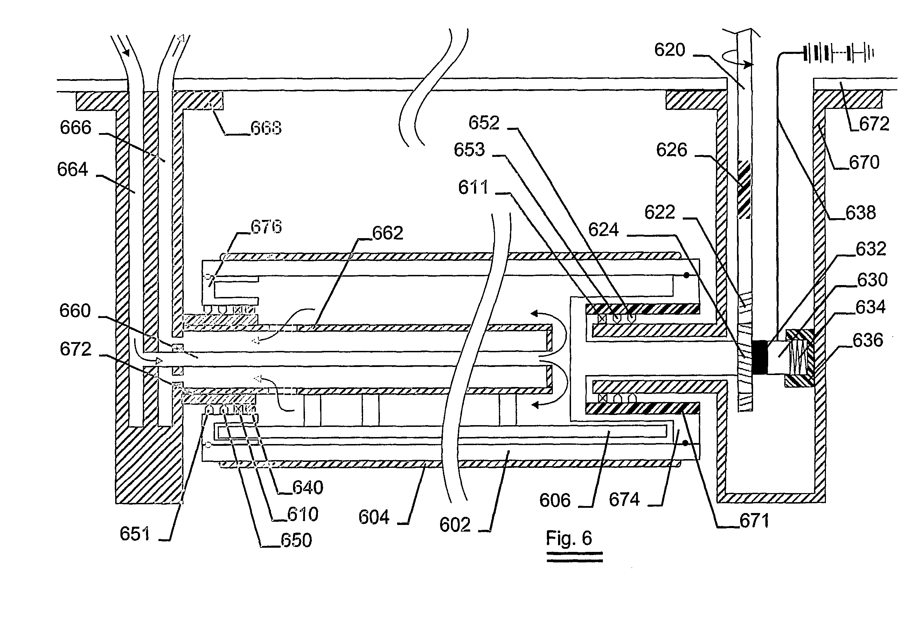

Another embodiment is depicted in FIGURE 6. Here the bearing system, the gas-to-vacuum seal and the gas-to-coolant seal are incorporated in the target tube, while the other functionalities are implemented outside the target tube. The target tube 602 is carried by two coupling means 668 and 670 that connect to the outside through the wall 672 of the sputtering apparatus. On the target tube 602 material to be sputtered 604 has been applied. The magnet array 606 is attached to a stationary carrier tube 662 that is firmly attached to coupling means 668. The coolant is fed through channel 664 and tube 660 coaxial to the carrier tube 662. The used coolant is evacuated through channel 666 after being collected in the space between outer tube 662 and inner tube 660. Motion is supplied to the target tube 602 by a shaft 620 foreseen of a worm 622 and gear 624 transmission. The gear 624 makes the insert 674 and the target tube 602 connected to it, turn. Electrical power is supplied through feed cable 638 that is electrically connected to a graphite brush 632 through a spring 634 activated connector piece 630. Electrically the coupling means 670 is isolated from the power supply by the isolator pieces 636 and 626. The two inserts 674 and 676 tightly fit into the ends of the target tube 602. Inside the insert 676 the following functionalities are incorporated so that they all are situated inside the target tube 602:
- the gas-to-vacuum seal 650. An additional gas-to-vacuum seal 651 has also been inserted in order to improve the quality of the seal.
- a gas-to-coolant seal 640
- one bearing ring 610 for rotatably carrying the target tube 602, situated between the gas-to-coolant seal 640 and the gas-to-vacuum seal 650

The coupling means 668 is electrically isolated by means of the insulator ring 672. Within the insert 674 the following functionalities have been incorporated inside the target tube 602:
- one bearing ring 611 for rotatably carrying the target tube 602
- a gas-to-vacuum seal 653 followed by another gas-to-vacuum seal 652 in order to improve the quality of the seal
No gas-to-coolant seal is needed at this side. The coupling means 670 is electrically isolated from the target tube by means of the insulator ring 671.

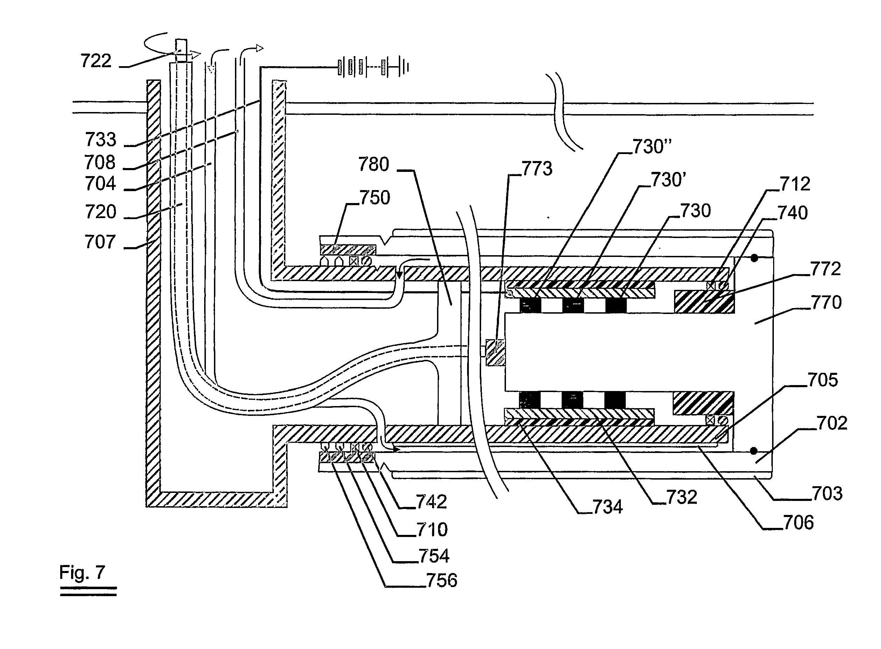

Another preferred embodiment is described in FIGURE 7. Here only the functionality of applying movement to the target tube 702 is situated outside the target tube. All other functionalities are integrated inside the target tube 702. The target tube 702 - with the target material 703 applied to it - is carried by a coupling means 707 perpendicular to which a carrier tube 705 is fixed. The assembly further consists of the magnet array 706 that is mounted on the carrier tube 705. The rotational motion is transferred from a motor (not shown) outside the sputtering apparatus to the tube by means of a flexible shaft 722. Such a flexible shaft rotates inside a protective sleeve 720. The sleeve 720 is connected to a fixture 780 that is immovably mounted inside the carrier tube 705. The shaft 722 itself is mechanically connected to the insert 770 through the electrically isolating piece 773. Cooling is provided through the coolant feeding tube 704 that feeds coolant in the space between the target tube 702 and the carrier tube 705. The coolant is evacuated through the exit tube 708. Electrical contact is ensured inside the target tube 702 through a series of parallelly connected ring-shaped graphite brushes 730, 730' and 730" placed between the rotating electrically conducting insert 770 and the stationary, cylindrical conductor 732. The cylindrical conductor 732 is connected to the power supply (not shown) through the conductor 733. The cylindrical conductor 732 is isolated from the carrier tube 705 by the isolator 734. The target tube 702 is rotatably born by the bearings 712 and 710 situated at the ends of the target tube 702. The bearing 710 is situated inbetween the gas-to-vacuum seals 754, 756 and the gas-to-coolant seal 742. At the bearing 712 , only a gas-to-coolant seal 740 is needed: there is no need of a gas-to-vacuum seal. The insert 770 and the carrier tube 705 are insulated from one another through the insulator 772. At the opposite end the target tube 702 is insulated from the carrier tube 705 by the insulator 750.

There are some parts of the design that have not been referenced - although drawn - but the functioning of which is clear to the person skilled in the art. For example where necessary, 'O'-ring seals have been incorporated in the design between pieces that are immovable to one another. As another example an insulated shield protects the first and second coupling means. Also fastening means such as e.g. screws or positioning pins have not been enumerated exhaustively in order to keep the explanation understandable.

## Claims

1. A target assembly comprising a rotatable target tube (200) and a central body (210,220,100) or a first and second central body, a bearing system (130,132,134,136) for rotatably supporting said tube by said body, a rotatable gas-to-coolant seal (170) for supplying or extracting coolant to said tube through said body, a rotatable gas-to-vacuum seal (135,131) for enabling a vacuum outside said tube,
**characterised in that**
said bearing system is placed between said gas-to-vacuum seal and said gas-to-coolant seal, said bearing system, said gas-to-vacuum seal and said gas-to-coolant seal being interior to said tube.

2. The target assembly according to claim 1 further comprising an electrical contact for rotatably connecting said body with said tube (164,166), said contact being interior to said tube.

3. The target assembly according to claim 1 or 2 further comprising a drive means for rotating said tube relative to said body, said drive means being interior to said tube.

4. The target assembly according claim 3 wherein said drive means is an electrical rotary motor (140).

5. The target assembly according claim 4 wherein said electrical rotary motor is a fixed axis, rotating drum motor (140).

6. The target assembly according claim 3 wherein said drive means is a hydraulic rotary motor (310).

7. The target assembly according claim 6 wherein said hydraulic rotary motor is driven by the coolant (310).

8. A target assembly according to any one of claim 1 to 7 with a first (210) and a second (220) central body said first and second body being insertable from either end of said tube.

9. The target assembly as in claim 1-7 wherein said first and second body are coupled to one another (210,220,100).

10. The target assembly as in claim 9, said assembly further comprising a magnet array (120), said magnet array coupling said first and second body to one another.

11. A sputtering apparatus positioned within walls of an evacuable chamber comprising a target assembly as in any one of claim 1 to 10, said apparatus further comprising one coupling means (010) connected to said chamber walls for removably coupling said central body or the first central body to said one coupling means.

12. The sputtering apparatus according to claim 11 further comprising a second coupling means (020) connected to said walls for removably coupling said central body or said first and second central body to said second coupling means.

## Patentansprüche

1. Targetanordnung mit einem drehbaren Targetrohr (200) und einem mittleren Körper (210, 220, 100) oder einem ersten und einem zweiten mittleren Körper, einem Lagersystem (130, 132, 134, 136) zum drehbaren Stützen des Rohrs durch den Körper, einer drehbaren Gas-Kühlmittel-Dichtung (170) zur Zuführung oder Extrahierung von Kühlmittel zu dem Rohr durch den Körper, einer drehbaren Gas-Vakuum-Dichtung (135, 131) zum Ermöglichen eines Vakuums außerhalb des Rohrs,
**dadurch gekennzeichnet, dass**
das Lagersystem zwischen der Gas-Vakuum-Dichtung und der Gas-Kühlmittel-Dichtung platziert ist, wobei sich das Lagersystem, die Gas-Vakuum-Dichtung und die Gas-Kühlmittel-Dichtung innerhalb des Rohrs befinden.

2. Targetanordnung nach Anspruch 1, die weiterhin einen elektrischen Kontakt zur drehbaren Verbindung des Körpers mit dem Rohr (164, 166) umfasst, wobei sich der Kontakt innerhalb des Rohrs befindet.

3. Targetanordnung nach Anspruch 1 oder 2, die weiterhin ein Antriebsmittel zum Drehen des Rohrs bezüglich des Körpers umfasst, wobei sich das Antriebsmittel innerhalb des Rohrs befindet.

4. Targetanordnung nach Anspruch 3, wobei das Antriebsmittel ein elektrischer Rotationsmotor (140) ist.

5. Targetanordnung nach Anspruch 4, wobei der elektrische Rotationsmotor ein Rotationstrommelmotor (140) mit fester Achse ist.

6. Targetanordnung nach Anspruch 3, wobei das Antriebsmittel ein hydraulischer Rotationsmotor (310) ist.

7. Targetanordnung nach Anspruch 6, wobei der hydraulische Rotationsmotor durch das Kühlmittel (310) angetrieben wird.

8. Targetanordnung nach einem der Ansprüche 1 bis 7 mit einem ersten (210) und einem zweiten (220) mittleren Körper, wobei der erste und der zweite Körper von beiden Enden des Rohrs eingeführt werden können.

9. Targetanordnung nach den Ansprüchen 1 - 7, wobei der erste und der zweite Körper miteinander verbunden sind (210, 220, 100).

10. Targetanordnung nach Anspruch 9, wobei die Anordnung weiterhin eine Magnetanordnung (120) umfasst, wobei die Magnetanordnung den ersten und den zweiten Körper miteinander verbindet.

11. Sputtervorrichtung, die innerhalb von Wänden einer evakuierbaren Kammer positioniert ist und eine Targetanordnung nach einem der Ansprüche 1 bis 10 umfasst, wobei die Vorrichtung weiterhin ein Verbindungsmittel (010) umfasst, das mit den Kammerwänden verbunden ist, um den mittleren Körper oder den ersten mittleren Körper lösbar mit dem einen Kupplungsmittel zu verbinden.

12. Sputtervorrichtung nach Anspruch 11, die weiterhin ein zweites Verbindungsmittel (020) umfasst, das mit den Wänden verbunden ist, um den mittleren Körper oder den ersten und zweiten mittleren Körper mit dem zweiten Verbindungsmittel zu verbinden.

## Revendications

1. Système de cible comprenant un tube de cible rotatif (200) et un corps central (210, 220, 100) ou un premier et un deuxième corps central, un système de palier (130, 132, 134, 136) pour faire supporter de manière rotative ledit tube par ledit corps, un joint rotatif gaz-à-milieu de refroidissement (170) pour alimenter ou extraire un milieu de refroidissement audit ou dudit tube à travers ledit corps, un joint rotatif gaz-à-vide (135, 131) pour permettre le maintien d'un vide à l'extérieur dudit tube,
**caractérisé en ce que**
ledit système de palier est placé entre ledit joint gaz-à-vide et ledit joint gaz-à-milieu de refroidissement, ledit système de palier, ledit joint gaz-à-vide et ledit joint gaz-à-milieu de refroidissement étant intérieurs audit tube.

2. Système de cible selon la revendication 1 comprenant en outre un contact électrique pour connecter de manière rotative ledit corps avec ledit tube (164, 166), ledit contact étant intérieur audit tube.

3. Système de cible selon la revendication 1 ou 2 comprenant en outre un moyen d'entraînement pour faire tourner ledit tube relativement audit corps, ledit moyen d'entraînement étant intérieur audit tube.

4. Système de cible selon la revendication 3, ledit moyen d'entraînement étant un moteur électrique rotatif (140).

5. Système de cible selon la revendication 4, ledit moteur électrique rotatif étant un moteur à tambour rotatif, à axe fixe (140).

6. Système de cible selon la revendication 3, ledit moyen d'entraînement étant un moteur hydraulique rotatif (310).

7. Système de cible selon la revendication 6, ledit moteur hydraulique rotatif étant entraîné par le milieu de refroidissement (310).

8. Système de cible selon l'une quelconque des revendications 1 à 7 avec un premier (210) et un deuxième (220) corps central, lesdits premier corps central et deuxième corps central pouvant être insérés par l'une ou l'autre des extrémités dudit tube.

9. Système de cible selon l'une quelconque des revendications 1 à 7, lesdits premier corps et deuxième corps étant raccordés l'un à l'autre (210, 220, 100).

10. Système de cible selon la revendication 9, ledit système comprenant en outre une rangée d'aimants (120), ladite rangée d'aimants raccordant lesdits premier corps et deuxième corps l'un à l'autre.

11. Dispositif de pulvérisation positionné entre les parois d'une chambre évacuable comprenant un système de cible selon l'une quelconque des revendications 1 à 10, ledit dispositif comprenant en outre un moyen de raccord (010) connecté auxdites parois de la chambre pour raccorder de manière libérable ledit corps central ou le premier corps central audit un moyen de raccord.

12. Dispositif de pulvérisation selon la revendication 11 comprenant en outre un deuxième moyen de raccord (020) connecté auxdites parois pour raccorder de manière libérable ledit corps central ou lesdits premier corps central et deuxième corps central audit deuxième moyen de raccord.
